# EUROPEAN PATENT APPLICATION

(11) **EP 4 625 729 A1**
(43) Date of publication of application: **01.10.2025**
(21) Application number: 23894588.5
(22) Date of filing: 21.11.2023
(51) Int. Cl.: H01S 5/183, H01S 5/343

(54) **VERTICAL CAVITY LIGHT EMITTING ELEMENT AND METHOD FOR PRODUCING SAME**

(30) Priority: 21.11.2022 JP 2022185420
(71) Applicant: Stanley Electric Co. Ltd., Tokyo 153-8636 (JP)
(72) Inventor: TSUDA Yuhzoh, Tokyo 153-8636 (JP); KURAMOTO Masaru, Tokyo 153-8636 (JP)
(74) Representative: Wimmer, Hubert
(86) International application number: PCT/JP2023/041821
(87) International publication number: WO 2024/111583

(57) **Abstract**

Problem

It is an objective to provide a long-life, highly efficient vertical cavity light-emitting element and a manufacturing method thereof while allowing a high carrier injection efficiency and suppressing a decrease in an element life.

Solution

The vertical cavity light-emitting element of the present invention includes a p-type AlGaN layer containing Mg as a p-type dopant. The p-type AlGaN layer has a configuration in which three or more AlGaN layers with different Al compositions stacked. When the p-type AlGaN layer defined in an Al composition curve in a layer thickness direction by SIMS is divided into a first region, a second region, and a third region having layer thicknesses of 1/10, 2/5, and 1/2 from an active layer side in this order, a size relationship of the Al compositions is the first region < the third region < the second region. A Mg concentration indicated by the Mg concentration curve is less than 1.2×10¹⁹ atoms/cm³ throughout an entire layer thickness of the p-type AlGaN layer and smallest in the first region, and in a region from a position of a peak position at which the Mg concentration is maximum in the second region to a peak position at which the Mg concentration is maximum in the third region, the Mg concentration is equal to or more than 3×10¹⁸ atoms/cm³, and a difference between a maximum value and a minimum value of the Mg concentration is equal to or less than 1.5×10¹⁸ atoms/cm³.

## Description

### TECHNICAL FIELD

The present invention relates to a vertical cavity semiconductor light-emitting element, such as a vertical cavity light-emitting element using a semiconductor multilayer film reflecting mirror, in particular a vertical cavity surface emitting laser (VCSEL). The present invention also relates to a manufacturing method of the vertical cavity light-emitting element.

### BACKGROUND ART

It is known that a vertical cavity light-emitting element includes distributed Bragg reflectors (DBR) above and below an active layer. In semiconductor light-emitting elements, it is known that an electron blocking layer with a band gap energy higher than that of the active layer is used to suppress the overflow of the electron carriers.

For example, in Patent Document 1, a vertical cavity light-emitting element is disclosed, which includes an AlGaN layer as an electron blocking layer between an active layer and a p-type semiconductor mesa structure constituted of a GaN-based semiconductor. In addition, in Patent Document 1, it is disclosed that the band gap energy is increased by increasing Al composition of the electron blocking layer.

Patent Document 1: Japanese Patent No. 6966843

### DISCLOSURE OF THE INVENTION

### PROBLEMS TO BE SOLVED BY THE INVENTION

For example, in the vertical cavity light-emitting element described above, when a p-type dopant concentration in a p-type AlGaN layer as the electron blocking layer is increased, concentration of the hole carriers increases, resulting in an effect of higher carrier injection efficiency. However, if the concentration of p-type dopant is increased too much, there is a problem that an element life is likely to decrease due to diffusion of the p-type dopant into the active layer and spread of defects in the active layer caused by the high concentration of the p-type dopant.

The present invention has been made in view of the above-described problem and an objective of which is to provide a long-life, highly efficient vertical cavity light-emitting element and a manufacturing method thereof while allowing a high carrier injection efficiency and suppressing a decrease in an element life.

### SOLUTIONS TO THE PROBLEMS

A vertical cavity light-emitting element according to the invention includes a substrate, a first multilayer film reflecting mirror, an n-type nitride semiconductor layer, an active layer, a p-type AlGaN layer, a p-type nitride semiconductor layer, and a second multilayer film reflecting mirror. The first multilayer film reflecting mirror is a semiconductor multilayer film in which two semiconductor layers with mutually different refractive indices are stacked alternately a plurality of times on the substrate. **The n-type** nitride semiconductor layer is formed on the first multilayer film reflecting mirror and made of a nitride semiconductor containing an n-type dopant. The active layer is formed on the n-type nitride semiconductor layer. The p-type AlGaN layer is formed on the active layer and containing Mg as a p-type dopant, the p-type AlGaN layer having a configuration in which three or more AlGaN layers with different Al compositions are stacked. The p-type nitride semiconductor layer is formed on the p-type AlGaN layer, the p-type nitride semiconductor layer being a semiconductor layer made of a nitride semiconductor containing a p-type dopant. The second multilayer film reflecting mirror is formed on the p-type nitride semiconductor layer and provided in a position opposed to the first multilayer film reflecting mirror. In an Al composition curve indicating a change in Al composition in a layer thickness direction in the p-type AlGaN layer and a Mg concentration curve indicating a change in Mg concentration in the layer thickness direction in the p-type AlGaN layer analyzed by a secondary ion mass spectrometry (SIMS) of the p-type AlGaN layer, when a width range at 50% of the peak value of the Al composition curve is defined as the p-type AlGaN layer, and the p-type AlGaN layer is divided into a first region having a layer thickness of 1/10 of the p-type AlGaN layer, a second region having a layer thickness of 2/5 of the p-type AlGaN layer, and a third region having a layer thickness of 1/2 of the p-type AlGaN layer in the layer thickness direction from the active layer side in this order, a size relationship among the Al compositions indicated by the Al composition curve in the respective regions is the first region < the third region < the second region, a Mg concentration indicated by the Mg concentration curve is less than 1.2×10¹⁹ atoms/cm³ throughout an entire layer thickness of the p-type AlGaN layer, and the Mg concentration is smallest in the first region among the first region to the third region, and a region from a peak position at which the concentration is maximum among peak positions of the Mg concentration in the second region to a peak position at which the concentration is maximum among peak positions of the Mg concentration in the third region is set as a fourth region, the Mg concentration is equal to or more than 3×10¹⁸ atoms/cm³ in the fourth region, and a difference between a maximum value and a minimum value of the Mg concentration in the fourth region is equal to or less than 1.5×10¹⁸ atoms/cm³.

A vertical cavity light-emitting element according to the invention includes a substrate, a first multilayer film reflecting mirror, an n-type nitride semiconductor layer, an active layer, a p-type AlGaN layer, a p-type nitride semiconductor layer, and a second multilayer film reflecting mirror. The first multilayer film reflecting mirror is a semiconductor multilayer film in which two semiconductor layers with mutually different refractive indices are stacked alternately a plurality of times on the substrate. The n-type nitride semiconductor layer is formed on the first multilayer film reflecting mirror and made of a nitride semiconductor containing an n-type dopant. The active layer is formed on the n-type nitride semiconductor layer. The p-type AlGaN layer is formed on the active layer and containing Mg as a p-type dopant, the p-type AlGaN layer having a configuration in which three or more AlGaN layers with different Al compositions are stacked. The p-type nitride semiconductor layer formed on the p-type AlGaN layer, the p-type nitride semiconductor layer being a semiconductor layer made of a nitride semiconductor containing a p-type dopant. The second multilayer film reflecting mirror is formed on the p-type nitride semiconductor layer and provided in a position opposed to the first multilayer film reflecting mirror. In an Al composition curve indicating a change in Al composition in a layer thickness direction in the p-type AlGaN layer and a Mg concentration curve indicating a change in Mg concentration in the layer thickness direction in the p-type AlGaN layer analyzed by a secondary ion mass spectrometry (SIMS) of the p-type AlGaN layer, when a width range at 50% of the peak value of the Al composition curve is defined as the p-type AlGaN layer, and the p-type AlGaN layer is divided into a first region having a layer thickness of 1/10 of the p-type AlGaN layer, a second region having a layer thickness of 2/5 of the p-type AlGaN layer, and a third region having a layer thickness of 1/2 of the p-type AlGaN layer in the layer thickness direction from the active layer side in this order, a size relationship among the Al compositions indicated by the Al composition curve in the respective regions is the first region < the third region < the second region, a Mg concentration indicated by the Mg concentration curve is less than 1.2×10¹⁹ atoms/cm³ throughout an entire layer thickness of the p-type AlGaN layer, and the Mg concentration is smallest in the first region among the first region to the third region, and a region from a peak position at which the concentration is maximum among peak positions of the Mg concentration in the second region to a peak position at which the concentration is maximum among peak positions of the Mg concentration in the third region is set as a fourth region, the Mg concentration is equal to or more than 3 ×10¹⁸ atoms/cm³ and is less than 8×10¹⁸ atoms/cm³ in the fourth region.

A manufacturing method of a vertical cavity light-emitting element by a metal-organic chemical vapor deposition (MOCVD) according to the invention includes: a step of forming a first multilayer film reflecting mirror by alternately growing two semiconductor layers with mutually different refractive indices on a substrate; an n-type nitride semiconductor layer growth step of growing an n-type nitride semiconductor layer on the first multilayer film reflecting mirror while supplying a material gas of n-type dopant; a step of forming an active layer on the n-type nitride semiconductor layer; a p-type AlGaN layer growth step of growing a p-type AlGaN layer as an AlGaN layer having a p-type conductivity type on the active layer while supplying a Mg material gas as a p-type dopant; a p-type nitride semiconductor layer growth step of growing a p-type nitride semiconductor layer on the p-type AlGaN layer; and a step of forming a second multilayer film reflecting mirror opposed to the first multilayer film reflecting mirror on the p-type nitride semiconductor layer. The p-type AlGaN layer growth step includes: a first growth step of growing a first p-type AlGaN layer by supplying a nitrogen source gas and a Ga material gas at a predetermined supply amount, supplying an Al material gas at a first supply amount, and supplying the Mg material gas at a second supply amount while increasing a growth temperature from a first temperature to a second temperature; a second growth step of growing a second p-type AlGaN layer by a maintaining step of maintaining the supply amount of the Mg material gas at the second supply amount for a first growth time while maintaining the supply amounts of the nitrogen source gas, the Ga material gas, and the Al material gas used in the first growth step after the first growth step, and thereafter, by a low Mg supply step of maintaining the supply amount of the Mg material gas for a second growth time after changing the supply amount to a third supply amount, the third supply amount being lower than the second supply amount; and a third growth step of growing a third p-type AlGaN layer while supplying the Al material gas at a fourth supply amount lower than the first supply amount and supplying the Mg material gas at a fifth supply amount lower than the second supply amount, after the second growth step.

### BRIEF DESCRIPTION OF THE DRAWINGS

FIG. 1 is a perspective view illustrating a configuration of a surface emitting laser according to an embodiment.
FIG. 2 is a top view illustrating a configuration of the surface emitting laser according to the embodiment.
FIG. 3 is a cross-sectional view illustrating a configuration of the surface emitting laser according to the embodiment.
FIG. 4 is a diagram showing a SIMS analysis result of a p-type AlGaN layer of the surface emitting laser according to the embodiment.
FIG. 5 is a flowchart illustrating an overview of a manufacturing process of the surface emitting laser according to the embodiment.
FIG. 6 is a diagram schematically illustrating a growth sequence of the p-type AlGaN layer of the surface emitting laser according to the embodiment.
FIG. 7 is a diagram showing a SIMS analysis result of a p-type AlGaN layer of a surface emitting laser according to Comparative Example 1.
FIG. 8 is a diagram showing a SIMS analysis result of a p-type AlGaN layer of a surface emitting laser according to Comparative Example 2.

### DESCRIPTION OF PREFERRED EMBODIMENTS

The following describes preferred embodiments of the present invention, but these may be modified and combined as appropriate. In the following description and accompanying drawings, substantially identical or equivalent parts are described using the same reference symbols.

### Embodiment

Referring to the attached drawings, a configuration of a vertical cavity surface emitting laser (VCSEL, hereinafter also simply referred to as a surface emitting laser) 10 according to an embodiment of the present invention is described. The surface emitting laser 10 of the embodiment is constituted of a nitride semiconductor layer.

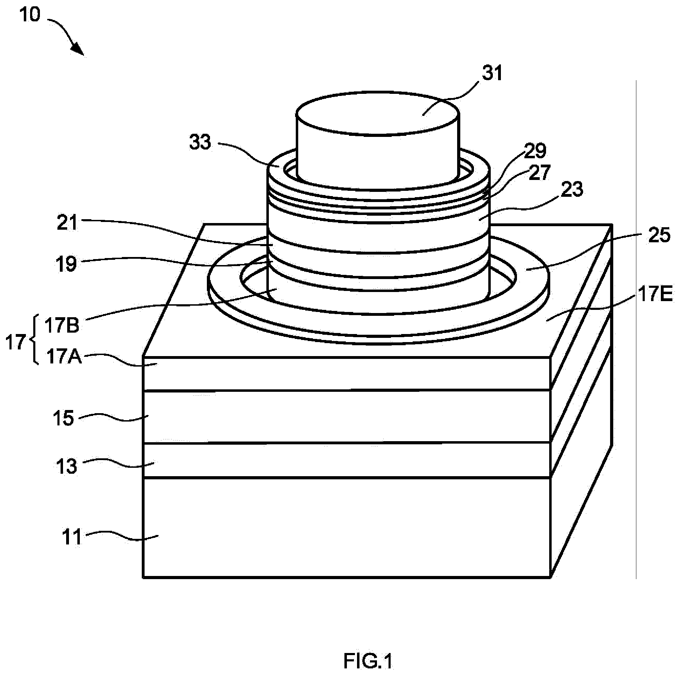

FIG. 1 is a perspective view illustrating an overview of the configuration of the surface emitting laser 10. A substrate 11 is a substrate for growing a nitride semiconductor layer constituting the surface emitting laser 10. For example, the substrate 11 has a rectangular top surface shape. In this embodiment, the substrate 11 is a GaN substrate. A top surface of the substrate 11, that is, a surface on which the nitride semiconductor layer is grown, is preferably a C-plane or a surface that is offset from the C-plane by equal to or less than 1°. In addition to the GaN substrate, a substrate such as a sapphire substrate and an AlN substrate can also be used as the substrate 11.

An underlayer 13 is formed on the substrate 11. The underlayer 13 is an undoped GaN layer. The underlayer 13 functions as a buffer layer to enhance crystallinity of the nitride semiconductor layer grown on the underlayer 13.

A first multilayer film reflecting mirror 15 is formed on the underlayer 13. The first multilayer film reflecting mirror 15 is a semiconductor multilayer film reflecting mirror in which a low refractive index semiconductor film with an AlInN composition and a high refractive index semiconductor film with a GaN composition having a higher refractive index than the low refractive index semiconductor film are alternately stacked. The first multilayer film reflecting mirror 15 is a distributed Bragg reflector (DBR) made of a nitride semiconductor material. In other words, the first multilayer film reflecting mirror 15 is a nitride semiconductor multilayer film reflecting mirror.

The n-type semiconductor layer 17 is an n-type GaN layer formed on the first multilayer film reflecting mirror 15. The n-type semiconductor layer 17 is doped with Si as an n-type impurity.

The n-type semiconductor layer 17 includes a prismatic-shaped lower portion 17A and a cylindrical upper portion 17B disposed on the lower portion 17A. In other words, the n-type semiconductor layer 17 includes the cylindrical upper portion 17B that protrudes from a top surface of the prismatic-shaped lower portion 17A. In other words, the n-type semiconductor layer 17 has a mesa-shaped structure that includes the upper portion 17B. The n-type semiconductor layer 17 includes an exposed portion 17E in which the top surface of the lower portion 17A is partially exposed.

An active layer 19 is formed on the upper portion 17B of the n-type semiconductor layer 17. The active layer 19 is an emission structure layer constituted of a plurality of semiconductor layers forming, for example, a multi-quantum well (MQW) structure. Specifically, the active layer 19 is a layer with a quantum well structure that includes a well layer with an InGaN composition and a barrier layer with a GaN composition. When a current is injected into the surface emitting laser 10, light is generated in the active layer 19.

An intermediate layer 21 is an undoped GaN layer formed on the active layer 19. The intermediate layer 21 has a buffer layer function that increases a distance between the active layer 19 and the p-type semiconductor layer 23 formed on the intermediate layer 21, in order to suppress impurities from diffusing from the p-type semiconductor layer 23 formed on the intermediate layer 21 into the active layer 19.

The p-type semiconductor layer 23 is formed on the intermediate layer 21 as described above, and is a layer that includes a plurality of semiconductor layers doped with a p-type impurity. Mg is doped as a p-type impurity in the p-type semiconductor layer 23.

An n-electrode 25 is a metal electrode provided on the exposed portion 17E of the n-type semiconductor layer 17. The n-electrode 25 is electrically connected to the n-type semiconductor layer 17. For example, the n-electrode 25 is formed in a ring shape surrounding the upper portion 17B of the n-type semiconductor layer 17. A shape of the n-electrode 25 is not limited thereto, and the n-electrode 25 may be, for example, an electrode layer formed in a layered shape over the entire surface of the exposed portion 17E.

An insulating layer 27, which is formed on the p-type semiconductor layer 23, is a layer made of an insulator or a material with a lower conductivity than the p-type semiconductor layer 23. The insulating layer 27 is constituted of a substance with a lower refractive index than the material constituting the p-type semiconductor layer 23, such as SiO₂. The insulating layer 27 is formed in a ring shape on the p-type semiconductor layer 23, and has an opening (not illustrated) in a center portion that exposes the p-type semiconductor layer 23.

A translucent electrode 29 is formed on the insulating layer 27. The translucent electrode 29 is also formed on the p-type semiconductor layer 23 through an opening in the insulating layer 27, and is electrically connected to the p-type semiconductor layer 23. The translucent electrode 29 is formed using a metal oxide that is translucent to the light emitted from the active layer 19, for example, ITO or IZO.

A second multilayer film reflecting mirror 31 is a dielectric multilayer film provided on the translucent electrode 29 on an opening in the insulating layer 27. The second multilayer film reflecting mirror 31 is a dielectric multilayer film mirror constituted of two dielectric films with different refractive indices, such as niobium oxide (Nb₂O₅) and silicon oxide (SiO₂), stacked alternately.

A p-electrode 33 is a metal electrode provided on the translucent electrode 29. The p-electrode 33 is electrically connected to the translucent electrode 29. The p-electrode 33 is formed in a ring shape surrounding the second multilayer film reflecting mirror 31.

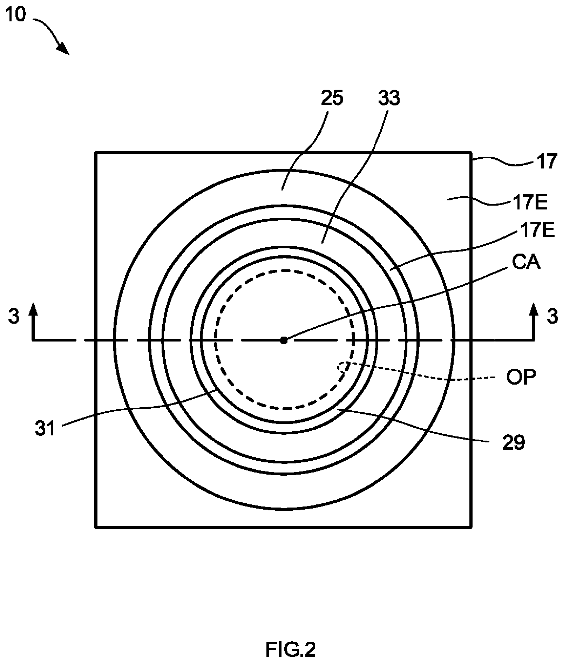

FIG. 2 is a top view of the surface emitting laser 10. As described above, the surface emitting laser 10 is formed on the substrate 11 having a rectangular top surface shape, and includes the n-type semiconductor layer 17 having a mesa-shaped structure.

The ring-shaped n-electrode 25 is formed on the exposed portion 17E, which is exposed from the mesa-shaped portion of the n-type semiconductor layer 17, so as to surround the mesa-shaped portion.

As described above, the surface emitting laser 10 includes the active layer 19, the intermediate layer 21, the p-type semiconductor layer 23, and the ring-shaped insulating layer 27 (not illustrated in FIG. 2) that are formed in this order on the upper portion 17B, which is the mesa-shaped portion of the n-type semiconductor layer 17, and have a circular top surface shape. The insulating layer 27 has an opening OP.

The translucent electrode 29 is formed on the insulating layer 27 so as to cover the opening OP of the insulating layer 27. The second multilayer film reflecting mirror 31 is provided in a region having a center CA of the translucent electrode 29 on the translucent electrode 29.

The second multilayer film reflecting mirror 31 is formed so as to cover the opening OP in a top view. The second multilayer film reflecting mirror 31 may be formed so as to overlap the opening OP in a top view. In addition, the ring-shaped p-electrode 33 is provided around a circumference of the translucent electrode 29.

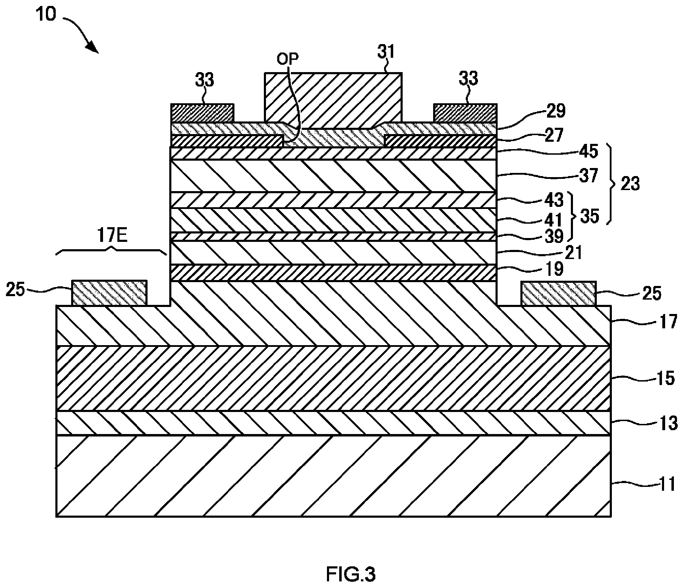

FIG. 3 is a cross-sectional view of the surface emitting laser 10 along the line 3-3 in FIG. 2. As described above, the p-type semiconductor layer 23 is configured including a plurality of semiconductor layers containing a p-type impurity. The following describes a configuration of the p-type semiconductor layer 23 and an upper layer side thereof with reference to FIG. 3.

A p-type AlGaN layer 35 is formed on the intermediate layer 21 and is a p-type AlGaN layer doped with Mg as a p-type impurity. The p-type AlGaN layer 35 functions as an electron blocking layer.

A p-type nitride semiconductor layer 37 is formed on the p-type AlGaN layer 35, and is a nitride semiconductor layer doped with a p-type impurity. The p-type nitride semiconductor layer 37 is, for example, a GaN layer doped with Mg as a p-type impurity.

In the surface emitting laser 10, a double heterostructure formed by the p-type nitride semiconductor layer 37, the n-type semiconductor layer 17, and the active layer 19 is formed. Due to such a structure, when a voltage is applied to the surface emitting laser 10 in a forward direction, electrons are injected from the n-type semiconductor layer 17 to the active layer 19, and the holes are injected from the p-type nitride semiconductor layer 37 to the active layer 19. The electrons and the holes are recombined in the active layer 19, and thus, light is generated.

In order to achieve efficiency in light emission in the surface emitting laser 10, it is important to efficiently inject the electron carriers and the hole carriers into the active layer 19 and keep them in the active layer 19, thereby keeping a threshold current density, which is a required current per unit area for laser oscillation, low. If the electron carriers injected from the n-type semiconductor layer 17 pass through the active layer 19 and an overflow of the electron carriers, which move to a side of the p-type nitride semiconductor layer 37, occurs, the threshold current density increases, and usage efficiency of the current decreases. In addition thereto, the element also deteriorates due to the effects of heat released by the carriers that do not contribute to luminescence, and the like, which decreases the element life.

The p-type AlGaN layer 35 disposed between the p-type nitride semiconductor layer 37 and the active layer 19 includes Al in the composition, which renders it to have a band gap energy higher than that of the p-type nitride semiconductor layer 37 constituted of GaN, thereby functioning as an electron blocking layer that suppresses the overflow of the electron carriers.

By doping Mg into the p-type AlGaN layer 35, which acts as the electron blocking layer, the hole carrier concentration of the p-type AlGaN layer 35 is increased and a Fermi level is lowered. This suppresses the carrier overflow and improves the carrier injection efficiency, which in turn suppresses the increase in the threshold current density of the surface emitting laser 10.

On the other hand, if the Mg concentration in the p-type AlGaN layer 35 is too high, the element life may decrease due to Mg diffusing into the active layer or due to defects caused by Mg spreading to the active layer.

The inventors of the present application have found that in order to increase the carrier injection efficiency while suppressing the above-described decrease in the element life caused by the Mg in the p-type AlGaN layer 35, it is important to precisely control the concentration distribution of the Mg in the p-type AlGaN layer 35 in a layer thickness direction together with the Al composition.

In this invention, the p-type AlGaN layer 35 is constituted of three layers of the p-type AlGaN layers with different Mg concentration distributions and Al composition distributions from one another. FIG. 3 illustrates the three layers constituting the p-type AlGaN layers 35 as a first p-type AlGaN layer 39, a second p-type AlGaN layer 41, and a third p-type AlGaN layer 43.

The Mg concentration is controlled such that the Mg concentration does not become too high in the first p-type AlGaN layer 39, which is closest to the active layer 19. The Mg concentration and the Al composition are controlled such that the Mg concentration and Mg concentration distribution are suitable for increasing the carrier injection efficiency in the second p-type AlGaN layer 41, which is adjacent to the first p-type AlGaN layer 39, and the third p-type AlGaN layer 43, which is farthest from the active layer.

As described above, the intermediate layer 21 is provided between the active layer 19 and the p-type semiconductor layer 23. The intermediate layer 21 has a function of increasing a distance between the p-type semiconductor layer 23 and the active layer 19, and suppressing the diffusion of p-type impurity into the active layer 19 and/or the effects of defects caused by p-type impurity. For example, the intermediate layer 21 is formed with a layer thickness of 30 to 145 nm. For example, the surface emitting laser 10 may be configured without the intermediate layer 21.

A p-type contact layer 45 is formed on the p-type nitride semiconductor layer 37, and is a nitride semiconductor layer doped with a higher concentration of p-type impurity than that in the p-type nitride semiconductor layer 37. The p-type contact layer 45 is, for example, a GaN layer doped with a higher concentration of Mg as a p-type impurity than that in the p-type nitride semiconductor layer 37.

Accordingly, the p-type semiconductor layer 23 is constituted of the p-type AlGaN layer 35, the p-type nitride semiconductor layer 37, and the p-type contact layer 45, which are stacked in this order.

The insulating layer 27 is formed on the p-type contact layer 45. As described above, the translucent electrode 29 is formed on the insulating layer 27 to cover the opening OP of the insulating layer 27, and the translucent electrode 29 is in contact with the p-type contact layer 45 through the opening OP.

The p-electrode 33 is electrically in contact with the translucent electrode 29. Therefore, the p-electrode 33 is electrically connected to the p-type semiconductor layer 23 via the translucent electrode 29.

In the surface emitting laser 10, the current is injected into the p-type semiconductor layer 23 from only a portion that is exposed by the opening OP of the insulating layer 27. Therefore, the opening OP serves as a current constriction structure that limits a range of current supply to the active layer 19.

In the surface emitting laser 10, the first multilayer film reflecting mirror 15 and the second multilayer film reflecting mirror 31 are arranged opposed to one another. The first multilayer film reflecting mirror 15 has a slightly lower reflectance than the second multilayer film reflecting mirror 31. Therefore, a part of the light that is emitted from the active layer 19 and resonates between the first multilayer film reflecting mirror 15 and the second multilayer film reflecting mirror 31 passes through the first multilayer film reflecting mirror 15 and the substrate 11, and is extracted to the outside.

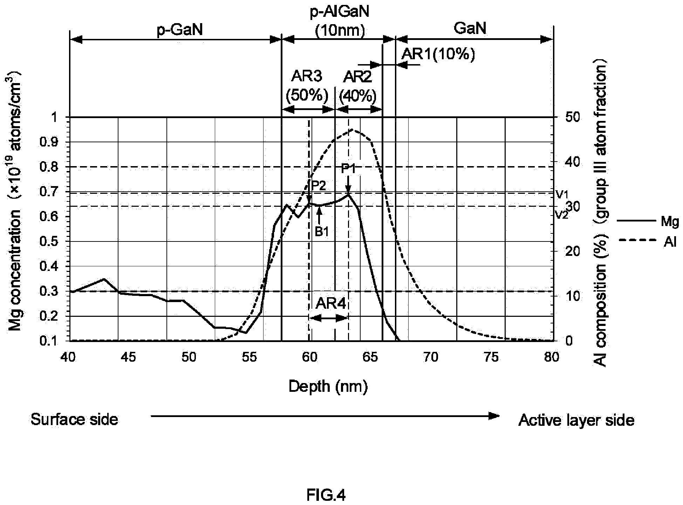

With reference to FIG. 4, the Al composition and the Mg concentration in the p-type AlGaN layer 35 is described. As described above, in order to enhance the function of the electron blocking layer by the p-type AlGaN layer 35, it is important to precisely control the concentration distribution of the Mg in the p-type AlGaN layer 35 in the layer thickness direction together with the Al composition. The Al composition and the concentration distribution of the Mg in the layer thickness direction are evaluable only by a secondary ion mass spectrometry (SIMS) analysis.

However, a SIMS analysis result of the Al composition and Mg concentration in the layer thickness direction does not match a design value. This is because the design does not allow the three layers constituting the p-type AlGaN layer 35 to be clearly distinguished due to the p-type AlGaN layer 35 of the present invention having a very thin layer thickness of approximately 7 to 15 nm in addition to the property of the SIMS analysis.

Specifically, in the SIMS analysis, primary ions are caused to collide on a sample surface, secondary ions released by sputtering are detected, and thus, concentration distributions of the elements in a depth direction in the sample are obtained.

When the analysis in the depth direction is proceeded, the primary ions with which the sample surface is irradiated mix with atoms constituting the sample, which generates ion beam mixing that disturbs the original distributions. Accordingly, the concentrations of the detected elements in the sample serve as averaged information up to a depth of mixing.

An unevenness that the sample originally has and/or an unevenness generated by the sputtering during the SIMS analysis on the sample surface, an interface with a lower layer, and the like causes a fluctuation of the concentration distribution of the sample in the depth direction (effects of roughness).

The ion beam mixing and the effects of roughness make it difficult to clearly distinguish boundaries in the stacked structure using the SIMS analysis. Even though such ion beam mixing and effects of roughness are reduced by optimization of measuring conditions and the like, clearly distinguishing the boundaries in the stacked structure is still difficult, and is further more difficult with the thin film of approximately 7 nm to 15 nm as in the present invention.

The present invention, therefore, has found an SIMS profile suitable for obtaining the surface emitting laser 10 with high efficiency and a long life by controlling changes in the Al composition and the Mg concentration of the p-type AlGaN layer 35 in the layer thickness direction on the basis of the SIMS analysis result.

FIG. 4 is a drawing illustrating a SIMS analysis result of the p-type AlGaN layer 35 of the surface emitting laser 10 according to the embodiment. FIG. 4 shows the Al composition profile and the Mg concentration profile in a depth direction, that is, the layer thickness direction, from the p-type nitride semiconductor layer 37, which is an upper layer of the p-type AlGaN layer 35, toward the intermediate layer 21, which is a lower layer of the p-type AlGaN layer 35 (that is, from the surface side to the active layer side (the substrate 11 side)).

In FIG. 4, the horizontal axis indicates the layer thickness from the surface side toward the active layer side, that is, the depth (nm), the main axis indicates the Mg concentration, and the secondary axis indicates the Al composition. In FIG. 4, the Al composition curve, which shows the change in the Al composition in the depth direction, is indicated as a broken line. In FIG. 4, the Mg concentration curve, which shows the change in the Mg concentration in the depth direction, is indicated as a solid line.

For the Al composition curve illustrated in FIG. 4, a range of a full width at half maximum as the width at 50% of the peak value, that is, the maximum value of the Al composition is defined as the p-type AlGaN layer 35. In this embodiment, the p-type AlGaN layer defined on the Al composition curve is divided into three regions in the layer thickness direction. Specifically, the p-type AlGaN layer 35 is divided into a region having a layer thickness of one-tenth (10%) as a first region AR1, a region having a layer thickness of two-fifths (40%) as a second region AR2, and a region having a layer thickness of half (50%) as a third region AR3 in this order from the active layer side toward the surface side in the layer thickness direction, and the Al composition and Mg concentration are described.

Therefore, when focusing on the horizontal axis indicating the layer thickness in the graph shown in FIG. 4, the above-described full width at half maximum corresponds to a total layer thickness of the p-type AlGaN layer 35, and on this horizontal axis, the first region AR1 corresponds to the layer thickness portion of one-tenth of the p-type AlGaN layer 35, the second region AR2 corresponds to the layer thickness portion of two-fifths, and the third region AR3 corresponds to the layer thickness portion of the one-half.

### [Mg Concentration Curve]

The Mg concentration and the profile control of the Mg concentration in the layer thickness direction indicated by the Mg concentration curve are described.

### [Mg Concentration of Entire p-type AlGaN Layer]

First, the Mg concentration control of the entire p-type AlGaN layer is described. When the peak concentration of the Mg in the p-type AlGaN layer 35 increases, the carrier injection efficiency improves due to the presence of a large amount of Mg, but on the other hand, the element life tends to decrease because Mg diffuses easily into the active layer and the defects caused by Mg tend to spread into the active layer.

The inventors have found that by controlling the peak concentration of the Mg in the p-type AlGaN layer 35 to less than 1.2×10¹⁹ atoms/cm³, and more preferably to less than 1×10¹⁹ atoms/cm³, it is possible to suppress the decrease in the element life caused by the diffusion of the high concentration of Mg or the defects caused by Mg spreading in the active layer as described above, and the lifespan of the surface emitting laser 10 improves more significantly than the conventional ones. In particular, by controlling the peak concentration of the Mg in the p-type AlGaN layer 35 to less than 1×10¹⁹ atoms/cm³, it is possible to significantly suppress the decrease in the element life caused by the defects caused by doping the high concentration of Mg spreading into the active layer.

In the example illustrated in FIG. 4, the maximum value of the Mg concentration indicated by the Mg concentration curve is approximately 6.9×10¹⁸ atoms/cm³, and is controlled to be less than 1×10¹⁹ atoms/cm³ throughout the entire layer thickness of the p-type AlGaN layer 35. By controlling the Mg concentration to less than 1×10¹⁹ atoms/cm³, the diffusion of Mg into the active layer and the spread of the defects caused by Mg into the active layer are suppressed. Thus, the decrease in the element life caused by the high Mg concentration is suppressed.

Subsequently, the Mg concentration control in each region of the first region to the third region will be described.

### [Mg Concentration in First Region]

Among the regions of the p-type AlGaN layer 35 in the layer thickness direction, the closer the distance to the active layer 19, the easier it is for Mg to diffuse into the active layer 19, and the easier it is for the defects caused by Mg to spread into the active layer. Considering these things, it is preferable that the Mg concentration in the first region AR1, which is closest to the active layer 19, is the lowest. Specifically, the Mg concentration in the first region is preferred to be less than 2×10¹⁸ atoms/cm³. By controlling the Mg concentration in the first region closest to the active layer to be less than 2×10¹⁸ atoms/cm³, the effects of suppressing the diffusion of Mg into the active layer and the spread of the defects caused by Mg are enhanced, thereby improving the element life.

As illustrated in FIG. 4, in this embodiment, when the mean values of the Mg concentrations in the respective regions indicated by the Mg concentration curve are compared between the respective regions, the first region AR1 is the smallest. Accordingly, by making the Mg concentration in the first region AR1, which is closest to the active layer 19, the lowest, the diffusion of Mg into the active layer and the spread of the defects caused by Mg into the active layer are suppressed, and the decrease in the element life caused by the high concentrations of Mg is suppressed.

### [Mg Concentrations in Second Region and Third Region]

The inventors have found that, by making the Al composition in the second region be the highest, and appropriately controlling the Mg concentration profiles in the second region and the third region, the carrier overflow suppressing effect is sufficiently obtained while suppressing the Mg concentration, thereby reducing the threshold current density thus improving the element life.

Specifically, there has been found that, from the second region to the third region, the Mg concentration indicated by the Mg concentration curve is approximately constant at an appropriate concentration, and by controlling to make a region with an approximately flat profile (hereinafter also simply referred to as a flat region), the carrier overflow suppressing effect is sufficiently obtained while suppressing the Mg concentration, thereby reducing the threshold current density thus improving the element life.

The appropriate Mg concentration in the flat region is a concentration that suppresses the decrease in the element life caused by Mg. Specifically, the Mg concentration in the flat region is less than 1.2×10¹⁹ atoms/cm³, more preferably less than 1×10¹⁹ atoms/cm³, and further preferably less than 8×10¹⁸ atoms/cm³.

The appropriate Mg concentration in the flat region is a concentration at which the carrier overflow suppressing effect is sufficiently obtained. Specifically, the Mg concentration in the flat region is preferred to be equal to or more than 3×10¹⁸ atoms/cm³.

Accordingly, in the above-described flat region, the Mg concentration indicated by the Mg concentration curve is preferably 3×10¹⁸atoms/cm³ or more and less than 1.2×10¹⁹ atoms/cm³, and more preferably less than 1.0×10¹⁹ atoms/cm³. Furthermore, in the flat region, the Mg concentration is preferably 3×10¹⁸atoms/cm³ or more and less than 8×10¹⁸ atoms/cm³.

Furthermore, from the aspect of sufficiently obtaining the carrier overflow suppressing effect, the Mg concentration of the flat region is preferred to be as high as possible within a range of 3 × 10¹⁸ atoms/cm³ or more and less than 8×10¹⁸ atoms/cm³.

Those having a region with an appropriate Mg concentration and a flat profile from the second region to the third region as described above is said to be, for one example, those having a region with a Mg concentration curve indicating a Mg concentration of 3 ×10¹⁸ atoms/cm³ or more and less than 8×10¹⁸ atoms/cm³ from the second region to the third region.

Those having a region with an appropriate Mg concentration and a flat profile from the second region to the third region is said to be, for one example, when a region from a peak position (P1 in the figure) at which the concentration is maximum among the peak positions in the second region to a peak position (P2 in the figure) at which the concentration is maximum among the peak positions in the third region is defined as a fourth region AR4, and a peak position at which the Mg concentration is minimum in the fourth region AR4 is B1 in the figure, those having a Mg concentration curve indicating a Mg concentration of 3×10¹⁸ atoms/cm³ or more in the fourth region AR4 and a difference between the maximum value and the minimum value of the Mg concentration in the fourth region AR4 of 1.5×10¹⁸ atoms/cm³ or less.

The peak position herein is a portion in which the Mg concentration takes the local maximum value or the local minimal value, and the Mg concentration curve can have a plurality of peak positions. The peak P1 is a peak with the local maximum value close to a boundary between the second region and the third region among the peaks in the second region, and the peak P2 is a peak with the local maximum value close to the boundary between the second region and the third region among the peaks in the third region. A peak B1 is a peak where the Mg concentration takes the local minimal value in the fourth region and the Mg concentration is minimum in the fourth region.

In relation to P1 and P2 that define the above-described fourth region, P1 is not necessarily the peak closest to the boundary between the second region and the third region in the second region, and P2 is not necessarily the peak closest to the boundary between the second region and the third region in the third region. The fourth region may be defined by using other peaks. For example, the peak positions with the maximum Mg concentrations among each of the peaks in the second region and the third region may be P1 and P2. Note that, while in the above-described example, the minimum value of the Mg concentration in the fourth region is the value of the peak B1, that is, the local minimal value, the minimum value of the Mg concentration in the fourth region is not always the local minimal value. For example, when the difference between the maximum value and the minimum value of the Mg concentration in the fourth region AR4 is obtained, regardless whether it is the local minimal value or not, it is only necessary to obtain the difference from the maximum value by using the minimum value of the Mg concentration in the fourth region AR4.

Note that the region with the flat profile from the second region to the third region is said to be, for example, a region from the half of the second region up to the third region, from the active layer side, in other words, a region from a position at approximately 3 nm from the active layer side in the p-type AlGaN layer 35 to a position at approximately 10 nm. The flat region is also said to be a region including at least the boundary between the second region and the third region.

In the example illustrated in FIG. 4, the maximum value (V1 in the figure) of the Mg concentration in the fourth region was approximately 6.9×10¹⁸ atoms/cm³, the minimum value (V2 in the figure) was approximately 6.4×10¹⁸ atoms/cm³, and their difference was approximately 0.5×10¹⁸ atoms/cm³. Here, V1 indicates a value of the peak P1, and V2 indicates a value of the peak B1. Thus, an approximately flat profile with the Mg concentration being distributed in a narrow range was obtained in the fourth region.

Note that in the example illustrated in FIG. 4, since the Mg concentration curve in the region from the position at approximately 3 nm to the position at approximately 10 nm from the active layer side of the p-type AlGaN layer 35 is flat, the shape of the Mg concentration curve in the p-type AlGaN layer 35 is generally in a shape close to a rectangular.

The surface emitting laser 10 including such a p-type AlGaN layer 35 had an element life of 5400 hours. Here, the element life indicates a time period from the beginning of an optical output (100%) until a half of the optical output (50%) is reached.

### [Al Composition Curve]

The Al composition curve shown in FIG. 4 has the peak in the second region AR2. In more detail, when comparing the mean values of the Al compositions in the respective regions indicated by the Al composition curve between the respective regions, the second region AR2 is the largest, the third region AR3 is the next largest, and the first region AR1 is the smallest (the first region AR1 < the third region AR3 < the second region AR2).

Increasing the Al composition in the region with the low Mg concentration increases the operating voltage. Thus, in the first region AR1, where the Mg concentration is low, the Al composition is also lowered to suppress the increase in the operating voltage.

**In addition,** by making the Al composition in the second region AR2 the highest, the barrier potential can be increased, and the overflow of the electron carriers can be suppressed.

Furthermore, by making only the Al composition of the second region AR2 the highest, rather than increasing the Al composition of the entire p-type AlGaN layer, it is possible to suppress the generation of cracks due to a lattice mismatch between the Al-rich layer and the adjacent GaN layer.

As described above, the surface emitting laser 10 of the embodiment is configured including: a first multilayer film reflecting mirror stacked on a substrate; an n-type nitride semiconductor layer formed on the first multilayer film reflecting mirror; an active layer formed on the n-type nitride semiconductor layer; a p-type AlGaN layer formed on the active layer, containing Mg as a p-type dopant, and having a structure in which three AlGaN layers with different Al compositions are stacked; a p-type nitride semiconductor layer formed on the p-type AlGaN layer; and a second multilayer film reflecting mirror formed on the p-type semiconductor layer and provided in a position opposed to the first multilayer film reflecting mirror.

As described above, the p-type AlGaN layer in the surface emitting laser according to the present invention has a size relationship among the Al compositions indicated by the Al composition curve in the respective regions described above of the first region < the third region < the second region, a Mg concentration indicated by the Mg concentration curve of less than 1.2×10¹⁹ atoms/cm³ throughout an entire layer thickness of the p-type AlGaN layer, and the Mg concentration is smallest in the first region among the first region to the third region, a region from a peak position at which the concentration is maximum among the peak positions of the Mg concentration in the second region to a peak position at which the concentration is maximum among the peak positions of the Mg concentration in the third region is set as a fourth region, the Mg concentration is equal to or more than 3×10¹⁸atoms/cm³ in the fourth region, and a difference between the maximum value and the minimum value of the Mg concentration in the fourth region is equal to or less than 1.5×10¹⁸ atoms/cm³.

From the different point of view, the p-type AlGaN layer in the surface emitting laser according to the present invention has a size relationship among the Al compositions indicated by the Al composition curve in the respective regions of the first region < the third region < the second region, the Mg concentration indicated by the Mg concentration curve is less than 1.2×10¹⁹ atoms/cm³ throughout the entire layer thickness of the p-type AlGaN layer and the Mg concentration is smallest in the first region among the first region to the third region, and a region with the Mg concentration of 3×10¹⁸ atoms/cm³ or more and less than 8×10¹⁸ atoms/cm³ is provided from the second region to the third region.

Due to the above-described structure, the p-type AlGaN layer in the surface emitting laser according to the present invention has the appropriate amount of Mg contained in the appropriate region in the layer thickness direction. Specifically, the p-type AlGaN layer in the embodiment exhibits the lowest Mg concentration in the first region close to the active layer, and exhibits the necessary and sufficient amount of the Mg concentration of 3 ×10¹⁸ atoms/cm³ or more in the region from the second region to the third region, for example, in the above-described fourth region in the SIMS profile. Accordingly, while ensuring the sufficient hole carrier concentration in the p-type AlGaN layer, the decrease in the element life caused by excessive Mg can be suppressed.

Accordingly, the surface emitting laser 10 of the embodiment can suppress the decrease in the life of the element while ensuring the high carrier injection efficiency, and can provide the long-life, highly efficient vertical cavity light-emitting element.

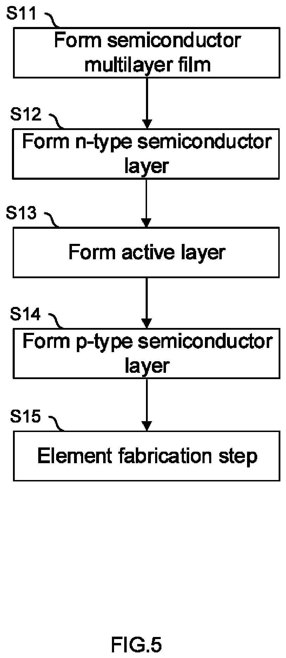

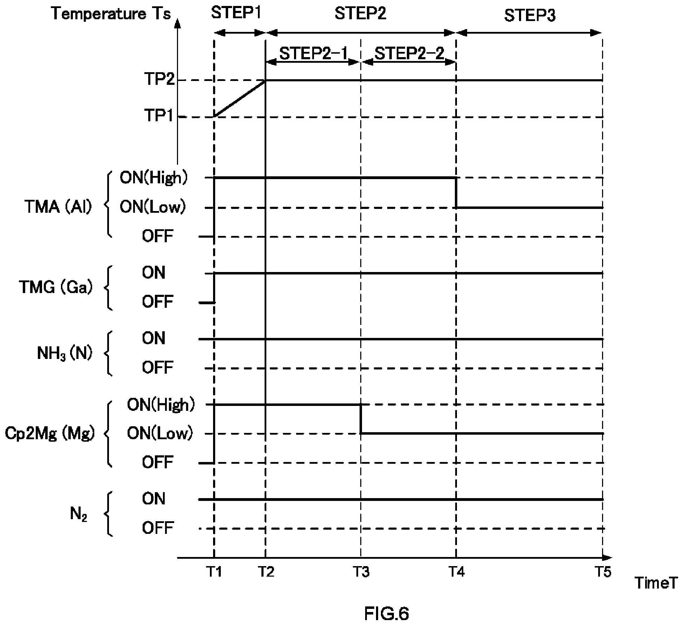

Referring to FIGS. 5 and 6, one example of a manufacturing method of the surface emitting laser 10 is described. FIG. 5 is a flowchart illustrating an overview of a manufacturing process of the surface emitting laser 10. The formation of each semiconductor layer was performed using a metal-organic chemical vapor deposition (MOCVD) method.

First, the underlayer 13 was formed on the substrate 11, and then the first multilayer film reflecting mirror 15 was formed on the underlayer 13 (Step S11).

A C-plane GaN substrate was used for the substrate 11 as a growth substrate. Although not illustrated in the diagram, in a semiconductor layer growth device, the substrate 11 is placed on a susceptor. In addition, a thermocouple is placed under the susceptor, and a temperature of the thermocouple is referred to as a "substrate temperature" in this specification. In addition, a "growth temperature" in this specification refers to the substrate temperature.

In Step S11, the temperature of the substrate 11 was first raised to 1200°C, and the underlayer 13 made of undoped GaN was grown with a layer thickness of 100 nm by supplying trimethylgallium (hereinafter referred to as TMG) and ammonia (NH₃) gas in a hydrogen carrier gas (ambient gas). In the case of homoepitaxial growth, it is not necessary to stack the underlayer 13, and it is optional.

Subsequently, the first multilayer film reflecting mirror 15 was then formed. A semiconductor distributed bragg reflector (DBR) of a stacked body made of InAlN/GaN was grown on the underlayer 13.

First, an InAlN layer was grown on the underlayer 13. The substrate temperature was set to 950°C, and the carrier gas was nitrogen (N₂) gas. Trimethylindium (hereinafter referred to as TMI), which is an In material gas, trimethylaluminum (hereinafter referred to as TMA), which is an Al material gas, and ammonia gas were supplied in order to grow the InAlN layer.

Subsequently, a GaN layer was grown on the InAlN layer. The substrate temperature was increased to 1100°C, the carrier gas was changed to hydrogen gas, and trimethylgallium (hereinafter referred to as TMG), which is a Ga material gas, and ammonia gas were supplied to form a GaN layer on the InAlN layer.

After that, the process of growing the InAlN layer and the process of growing the GaN layer described above were repeated a further 40 times, and a total of 41 pairs of the InAlN layers and the GaN layers were stacked. AlInN and GaN were formed in layers on a (0001) plane of a crystal plane of the substrate 11, and the thickness of each layer was made to be 1/4 of an optical layer thickness for a desired wavelength.

After that, an n-type semiconductor layer 17 was formed on the first multilayer film reflecting mirror 15 (Step S12). In Step S12, with a substrate temperature of 1200°C and hydrogen gas as the carrier gas, TMG as the gallium material gas, ammonia gas as the nitrogen source gas, and disilane (Si₂H₆) as a n-type dopant material gas and a silicon-containing gas were supplied to form an n-type GaN layer with a layer thickness of 1500 nm doped with 3×10¹⁸atoms/cm³ Si on the first multilayer film reflecting mirror 15.

After the formation of the n-type semiconductor layer 17, the active layer 19 was stacked on the n-type semiconductor layer 17 (Step S13). In Step S13, a multi-quantum well layer (hereinafter referred to as "MQW") was formed on the n-type semiconductor layer 17. The barrier layer and the well layer are made of InₓAl_{y}Ga_{1-x-y}N. In this embodiment, a 3 nm undoped InGaN (y=0) as a well layer and a 4 nm undoped GaN (x=y=0) as a barrier layer were stacked five times to form a MQW constituted of five pairs. Here, the composition ratio x of In can be appropriately adjusted for the oscillation wavelength.

After the active layer 19 was formed, a p-type semiconductor layer 23 was formed on the active layer 19 (Step S14). In Step 14, a GaN layer having a layer thickness of 130 nm was formed as the intermediate layer 21 on the active layer 19, and the p-type semiconductor layer 23 was formed on the intermediate layer 21.

In Step S14, the p-type AlGaN layer 35, the p-type nitride semiconductor layer 37, and the p-type contact layer 45 were formed in this order as the p-type semiconductor layer 23. Here, with reference to FIG. 6, the method for growing the p-type AlGaN layer 35 is described in detail.

FIG. 6 schematically illustrates a diagram of a growth sequence (p-type AlGaN layer growth step) of the p-type AlGaN layer 35 of the surface emitting laser 10. In FIG. 6, the horizontal axis indicates time T. In addition, the vertical axis in FIG. 6 indicates substrate temperature Ts. In FIG. 6, the ON state or the OFF state is indicated for each supplied gas type, which indicates whether or not it is being supplied, along with the change in the substrate temperature Ts over time. In addition, among the types of supplied gas, for an Al material gas (TMA) and a Mg material gas (bis-cyclopentadienyl magnesium (hereinafter referred to as "Cp2Mg")), the ON state is indicated as ON (High) when supplied in a large supply amount, and as ON (Low) when supplied in a small supply amount.

As illustrated in FIG. 6, the p-type AlGaN layer 35 was grown in three steps of first to third growth steps (STEPS 1 to 3 in the figure). A design value of a layer thickness of the p-type AlGaN layer 35 is 10 nm.

First, in the first growth step (STEP 1 in the figure), while the substrate temperature was increased from TP1 (950°C, a first temperature) to TP2 (1000°C, a second temperature) over a period of 30 seconds (T1 to T2), with the carrier gas of nitrogen gas and ammonia gas, TMA as the Al material gas at 9.4 sccm (Standard Cubic Centimeter per Minute) (the first supply amount, ON (High) in the figure) and TMG as the Ga material gas at 1.6 sccm were supplied, and further a Mg material gas (Cp2Mg) at 37.2 sccm (the second supply amount, ON (High) in the figure) was supplied in order to grow the first p-type AlGaN layer 39. The ammonia gas is used as the nitrogen source for the p-type AlGaN layer 35. A design value of a layer thickness of the first p-type AlGaN layer is 0.8 nm. A design value of an Al composition of the first p-type AlGaN layer is 25%.

A second growth step (STEP2 in the figure) was divided into two steps of a step 2-1 and a step 2-2 to grow the second p-type AlGaN layer 41. A design value of a layer thickness of the second p-type AlGaN layer is 5.2 nm. A design value of an Al composition of the second p-type AlGaN layer 41 is 42%. Note that the step 2-1 is defined to be started at a time point (T2) at which the temperature reaches 1000°C.

In the step 2-1 as a maintaining step, a substrate temperature was maintained at TP2 (1000°C), TMA, TMG, ammonia gas, nitrogen gas, and Cp2Mg were continuously supplied while maintaining the supply amount in the first growth step, and the second p-type AlGaN layer was grown to have 2.6 nm in a design value (T2 to T3 (a first growth time) 118 seconds). In the second growth step, a first supply amount of TMA and a second supply amount of Cp2Mg were maintained and supplied.

Subsequently, the step 2-2 was started at a time T3. In the step 2-2 as a low Mg low supply step, the substrate temperature was maintained at TP2, while maintaining the supply amounts in the step 2-1 of TMA, TMG, ammonia gas, and nitrogen gas, Cp2Mg was supplied at 2.5 sccm (a third supply amount, ON (Low) in the figure) smaller than the second supply amount, and the second p-type AlGaN layer was grown to have 2.6 nm in a design value (T3 to T4 (the second growth time) 118 seconds).

That is, the second growth step is a step of changing the supply amount of the Mg material gas in its course, and is specifically, a step of decreasing the supply amount of the Mg material gas between the step 2-1 and the step 2-2. In this embodiment, at the beginning of the step 2-2, the supply amount of Cp2Mg as the Mg material gas was changed from 37.2 sccm to 2.5 sccm. While the supply amount of Cp2Mg is not limited thereto, the supply amount in the step 2-2 is preferred to be set to equal to or less than one-tenth of the supply amount at the step 2-1.

At a time T4, the third growth step (STEP3 in the figure) was started. In the third growth step, the substrate temperature was maintained at TP2, while maintaining the supply amounts of TMG, nitrogen gas, and ammonia gas, TMA was supplied at 4.9 sccm (a fourth supply amount, ON (Low) in the figure) smaller than the first supply amount and Cp2Mg was supplied at 2.5 sccm (a fifth supply amount, ON (Low) in the figure) smaller than the second supply amount to grow the third p-type AlGaN layer 43 (T4 to T5, 194 seconds). A design value of a layer thickness of the third p-type AlGaN layer is 4 nm. A design value of an Al composition of the third p-type AlGaN layer 43 is 28%.

While in this embodiment, the supply amount of the Mg material gas (Cp2Mg) in the third growth step is 2.5 sccm, which is the same as the supply amount (the third supply amount) in the step 2-2 in the second growth step, it is not limited thereto. The supply amount of the Mg material gas in the third growth step is only necessary to be smaller than the supply amount (the second supply amount) of the step 2-1, and is preferably equal to or less than one-tenth.

Accordingly, the p-type AlGaN layer 35 having a design value of 10 nm was formed. As described above, in the forming process of the p-type AlGaN layer 35, the supply amount of the Mg material gas is decreased as low as one-tenth or less of the supply amount by then after the first growth step (design value 0.8 nm) and the step 2-1 of the second growth step (design value 2.6 nm), that is, after the growth up to 3.4 nm in a design value, and thereafter, remains low until the end of growth of the p-type AlGaN layer 35.

However, in the region of the p-type AlGaN layer of the Mg concentration curve illustrated in FIG. 4, a tendency of a large decrease is not observed from the first region to the third region, that is, in the growth direction, and therefore, it does not correspond to the supply sequence of the Mg material gas.

This is due to a memory effect of Mg. In the MOCVD method, it is known that a phenomenon called the memory effect occurs, in which a solid-phase thermal diffusion of Mg dopant and Mg raw materials remaining in a chamber and the like unintentionally mix into the film.

For example, the Mg amount in the film formed in the third growth step is larger than an amount corresponding to the supply amount of Cp2Mg supplied in the third growth step. This is thought that the amount is added due to the memory effect causing Mg thermally diffused from the lower layer formed by the second growth step and Mg remaining in the chamber to mix into the film.

The above-described growth sequence takes into account these characteristics of Mg and adjusts the supply amount of the Mg source gas such that the desired SIMS profile can be obtained. Specifically, by making the supply amount of Cp2Mg in the step 2-2 of the second growth step (the third supply amount) and the supply amount of Cp2Mg in the third growth step (the fifth supply amount) equal to or less than one-tenth of the supply amount of Cp2Mg in the step 2-1 of the second growth step (the second supply amount), the Mg concentration is maintained not becoming too high due to the memory effect. Specifically, for example, it is maintained not exceeding 1.2 × 10¹⁹ atoms/cm³ throughout the entire p-type AlGaN layer 35.

Such a control allowed to obtain the Mg concentration curve that has the Mg concentration of 3×10¹⁸ atoms/cm³ or more and is flat from the second region AR2 to the third region AR3 described above. Specifically, the Mg concentration curve having the difference between the maximum value and the minimum value of the Mg concentration in the fourth region described above of equal to or less than 1.5×10¹⁸ atoms/cm³ was obtained. This Mg concentration curve may, for example, have a region with the Mg concentration of 3×10¹⁸ atoms/cm³ or more and less than 8×10¹⁸ atoms/cm³ from the second region to the third region regardless whether the difference between the maximum value and the minimum value of the Mg concentration in the fourth region is equal to or less than 1.5×10¹⁸ atoms/cm³ or not.

Note that the supply amount of the Mg material gas has not changed from the first growth step to the second growth step (STEP2-1), but the growth temperature is higher in the second growth step. The higher the substrate temperature is, the higher the decomposition efficiency of CP₂Mg becomes and the easier it is for Mg to be incorporated into the growth layer, and therefore, the Mg concentration in the first region is maintained low and the Mg concentration in the second region is increased in the Mg concentration curve. Furthermore, the increase in the Mg concentration from the first region to the second region is thought be related to the above-described memory effect as well in addition to the effect of the substrate temperature.

Note that the growth time in the step 2-1 is preferred to be equal to or less than the growth time in the step 2-2. That is because the increase in the Mg concentration due to the memory effect can be suppressed.

It is also possible to consider to use hydrogen gas as a carrier gas when the p-type AlGaN layer is grown, but the raw material transportation of the Mg material to the wafer is lowered in a nitrogen atmosphere compared with in a hydrogen atmosphere, and therefore, the mixture of Mg into the film is suppressed even when the supply amount of the Mg material gas is the same.

For example, as described above, it is preferred to maintain the Mg concentration specifically low in the first p-type AlGaN layer, and therefore, nitrogen gas is preferably used as the carrier gas in the first growth step. From the aspect of controllability of the distribution of the Mg concentration in the layer thickness direction in order to make the Mg concentration curve close to an approximately flat shape (the rectangular shape in general) in the second region and the third region, the nitrogen gas is preferably used as the carrier gas in the second growth step and the third growth step.

In this embodiment, by making the above-described improvements to the growth method, it is possible to form the p-type AlGaN layer 35 that produces the SIMS profile as indicated in FIG. 4. This in turn suppresses the increase in the threshold current density of the surface emitting laser 10 and also suppresses the decrease in the life.

After the p-type AlGaN layer 35 was formed, a p-type GaN layer doped with 5×10¹⁸ atoms/cm³ of Mg was formed as the p-type nitride semiconductor layer 37. After that, a p-type GaN contact layer doped with equal to or more than 5×10²⁰ atoms/cm³ of Mg was formed on the p-type nitride semiconductor layer 37 as the p-type contact layer 45, and the formation of the p-type semiconductor layer 23 was completed.

### [Element Fabrication Step]

After the p-type semiconductor layer was formed, Mg was activated by heat treatment in a rapid thermal annealing (hereinafter referred to as "RTA") device. After that, a mesa pattern was formed by photoresist, and dry etching was used to form a mesa structure while also forming the exposed portion 17E (see FIG. 1) where the n-type semiconductor layer 17 was partially exposed around this mesa structure. The photoresist was then removed.

Silicon oxide (SiO₂) was formed with a layer thickness of 150nm as the insulating layer 27 on the mesa structure and the exposed portion 17E by sputtering. A pattern was formed using photoresist, and etching was performed using buffered hydrofluoric acid (hereinafter referred to as "BHF"), and the opening OP was formed in the insulating layer 27 on the mesa structure as an opening for light emission. The photoresist was then removed.

Indium tin oxide (hereinafter referred to as "ITO") was formed as the translucent electrode 29 by sputtering to a thickness of approximately 17 nm. A pattern was formed using photoresist, and the ITO was etched using a mixed acid, forming the translucent electrode 29 on the insulating layer 27 on the mesa structure and on the p-type contact layer 45 exposed by the opening OP of the insulating layer 27. After that, the photoresist was removed, and heat treatment was performed using RTA to make the ITO transparent and improve its conductivity.

Using electron beam (hereinafter referred to as "EB") deposition, a p-side metal layer (the p-electrode 33) that does not cover the opening was formed on the translucent electrode 29 to a thickness of approximately 300 nm. A stacked body of platinum (Pt), gold (Au), and titanium (Ti) was used for the p-side metal layer. Next, the photoresist was removed after a lift-off using a chemical.

After forming a pattern with photoresist, the n-electrode 25, which is electrically connected to the exposed portion 17E of the n-type semiconductor layer 17, was formed by EB deposition to a thickness of about 700 nm. A stacked body of Ti, Al, Pt, and Au was used for the n-electrode. The photoresist was removed by a lift-off using a chemical.

Using EB deposition, 10.5 pairs (approx. 1300 nm) of a dielectric multilayer film (the dielectric multilayer film mirror, a dielectric DBR) were formed as the second multilayer film reflecting mirror 31 on the translucent electrode 29. A stacked body of niobium oxide (hereinafter, Nb₂O₅, with a film thickness of approx. 45 nm) and SiO₂ (with a film thickness of approx. 76 nm) was used for the dielectric DBR. Next, a dielectric DBR pattern was formed using photoresist, and unnecessary portions of the dielectric DBR (on the p-electrode and the n-electrode) were etched away using a dry etching device. Finally, the photoresist was removed using a chemical.

A pattern was formed using photoresist, and an additional p-side metal layer (not illustrated) electrically connected to the p-electrode was formed to a thickness of approximately 2200 nm using EB deposition. A stacked body of Ti, Pt, and Au was used for the p-electrode (the p-pad layer). Next, the photoresist was removed by a lift-off using a chemical. The element was fabricated in this way (Step S15).

The above-described steps were used to manufacture the surface emitting laser 10. Note that the above-described manufacturing process is merely an example, and the elements to be doped into the semiconductor, the dimensions of the respective members, and the like are changeable as necessary.

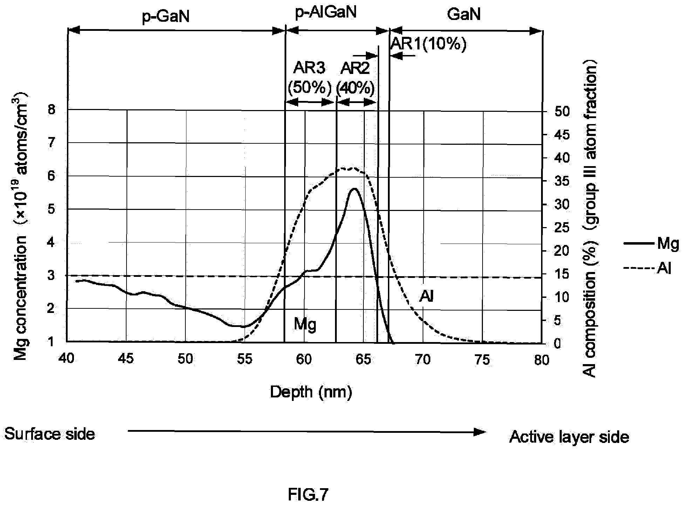

Referring to FIG. 7, a p-type AlGaN layer of a conventional surface emitting laser of Comparative Example 1 is described. The surface emitting laser of Comparative Example 1 is different from that of the embodiment in that it includes, instead of the p-type AlGaN layer 35, a p-type AlGaN layer grown with a constant supply amount of 4.9 sccm of the Al material gas (TMA) and a constant supply amount of 37.2 sccm of the Mg material gas (Cp₂Mg) with a design value of a layer thickness of 10 nm and a design value of an Al composition of 30%. The surface emitting laser of Comparative Example 1 is configured in the same way as that of the embodiment in all other respects. In other words, the p-type AlGaN layer of Comparative Example 1 was grown in a single step, and was grown using a method that differs from the growth method of the embodiment, which involves the three steps.

FIG. 7 shows a SIMS analysis result of the p-type AlGaN layer of the surface emitting laser of Comparative Example 1. As with the graph illustrated in FIG. 4, the broken line in FIG. 7 indicates the Al composition curve, which indicates the change in the Al composition in the depth direction, and the solid line indicates the Mg concentration curve, which indicates the change in the Mg concentration in the depth direction. As in the case of the embodiment illustrated in FIG. 4, the width at 50% of the maximum value of the Al composition is defined as the p-type AlGaN layer, and the p-type AlGaN layer is divided into the first region AR1 having a layer thickness of 10%, the second region AR2 having a layer thickness of 40%, and the third region AR3 having a layer thickness of 50%, in this order from the active layer side toward the surface side of the p-type AlGaN layer 35.

As illustrated in FIG. 7, the Mg concentration curve has a peak in the second region AR2, and exceeds 3×10¹⁹ atoms/cm³ in most of the second region AR2 and the third region AR3. Accordingly, when the Mg concentration in the second region becomes high concentration exceeding 3×10¹⁹ atoms/cm³, the carrier injection efficiency becomes high, but the diffusion of Mg into the active layer and the spread of defects caused by Mg into the active layer also occur more easily, and this reduces the element life.

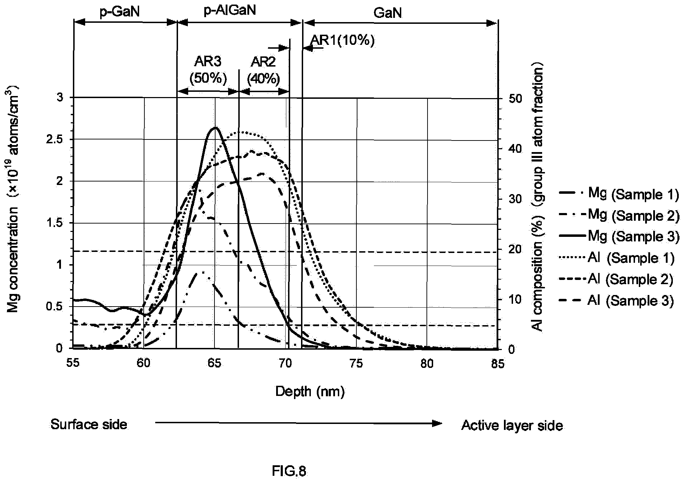

Referring to FIG. 8, a p-type AlGaN layer of a conventional surface emitting laser of Comparative Example 2 is described. The surface emitting laser of Comparative Example 2 is different from those of the embodiment or Comparative Example 1 in that it includes a p-type AlGaN layer that was grown using a different method than the p-type AlGaN layer 35 of the embodiment or the p-type AlGaN layer of Comparative Example 1, and in other respects it is configured in the same way as the embodiment.

The p-type AlGaN layer of Comparative Example 2 was grown such that the Mg concentration was less than 3×10¹⁹ atoms/cm³ throughout the entire layer thickness. In Comparative Example 2, respective three samples were made with maximum Mg concentrations of 0.9×10¹⁹ atoms/cm³, 2.0×10¹⁹ atoms/cm³, and 2.6×10¹⁹ atoms/cm³.

The sample with the maximum Mg concentration of 0.9×10¹⁹ atoms/cm³ (hereinafter referred to as "Sample 1") was grown by maintaining the supply amount of the Al material gas (TMA) at 6.0 sccm and the supply amount of the Mg material gas (Cp₂Mg) at 4.1 sccm, with a design value of a layer thickness of 10 nm and a design value of an Al composition of 32%.

For the sample with the maximum Mg concentration of 2.0×10¹⁹ atoms/cm³ (hereinafter referred to as "Sample 2") was grown by maintaining the supply amount of the Al material gas (TMA) at 6.2 sccm and the supply amount of the Mg material gas (Cp₂Mg) at 37.2 sccm up to 5 nm growth, and at 2.5 sccm since the 5 nm growth, and the sample was grown with a design value of a layer thickness of 10 nm and a design value of an Al composition of 33%.

For the sample with the maximum Mg concentration of 2.6×10¹⁹ atoms/cm³ (hereinafter referred to as "Sample 3") was grown by maintaining the supply amount of the Al material gas (TMA) at 4.9 sccm and the supply amount of the Mg material gas (Cp₂Mg) at 37.2 sccm up to 5 nm growth, and at 2.5 sccm since the 5 nm growth, and the sample was grown with a design value of a layer thickness of 10 nm and a design value of an Al composition of 30%.

FIG. 8 shows a SIMS analysis result of a p-type AlGaN layer of a surface emitting laser of Comparative Example 2. In FIG. 8, the Al composition curve, which indicates the change in the Al composition in the depth direction, is indicated as the broken line. The Mg concentration curves, which indicate the changes in the Mg concentrations in the depth directions, are indicated as a two-dot chain line for Sample 1, as a one-dot chain line for Sample 2, and as a solid line for Sample 3.

As illustrated in FIG. 8, the Mg concentration curves of Samples 1 to 3 had tendencies of having a peak in the third region AR3 far from the active layer 19. Since the peak is present in a region far from the active layer, it is preferable in that the diffusion of Mg into the active layer and the effect of defects caused by Mg on the active layer are unlikely to occur. However, Samples 1 to 3 had tendencies of lacking the Mg concentration in the second region AR2. Because of that, the surface emitting laser using Samples 1 to 3 tends to have a low suppressing effect of carrier overflow by Mg and a high threshold current density.

The Mg concentration curve of Sample 3 has the maximum Mg concentration exceeding 2.5×10¹⁹ atoms/cm³. While it is lower than Comparative Example 1, from the view point of suppressing the diffusion of Mg into the active layer and the effect of defects caused by Mg on the active layer, it is higher than the indicator of less than 1.2×10¹⁹ atoms/cm³ described above.

The Mg concentration curve of Sample 3 indicates a monotonous decrease toward the active layer in the second region AR2. In this case, it has been found that, despite the fact that the Mg concentration exceeds 3×10¹⁸atoms/cm³, which is one of the indicators for obtaining the sufficient hole carrier concentration in almost the entire second region AR2, the hole carrier concentration is insufficient, the overflow of the electron carriers is less likely to be suppressed, the carrier injection efficiency decreases, and the threshold current density increases.

The Mg concentration curve of Sample 2 has the maximum Mg concentration of approximately 2×10¹⁹ atoms/cm³. While it is lower than Sample 3, it is higher than the indicator of less than 1.2×10¹⁹ atoms/cm³ described above.

The Mg concentration curve of Sample 2 also indicates the Mg concentration decrease toward the active layer in the second region AR2, and even though the hole carrier concentration exceeds 3×10¹⁸ atoms/cm³, the hole carrier concentration is insufficient, the overflow of the electron carriers is less likely to be suppressed, the carrier injection efficiency decreases, and the threshold current density increases.

Since the Mg concentration curve of Sample 1 has the low maximum Mg concentration of less than 1×10¹⁹ atoms/cm³, it is preferable in that the diffusion of Mg into the active layer and the effect of defects caused by Mg on the active layer are unlikely to occur. However, Sample 1 has the Mg concentration in the second region AR2 further lower than the case of Sample 2, which is less than 3×10¹⁸atoms/cm³. Accordingly, also in Sample 1, the hole carrier concentration is insufficient, the overflow of the electron carriers is less likely to be suppressed, the carrier injection efficiency decreases, and the threshold current density increases.

As described with reference to FIGS. 7 and 8, in Comparative Example 1, a sample was prepared with a peak concentration of Mg of 3×10¹⁹ atoms/cm³ or more, and in Comparative Example 2, a sample was prepared with a peak concentration of Mg of less than 3×10¹⁹ atoms/cm³. In both cases, the carrier overflow suppressing effect by Mg was not appropriately obtained, and the element life was approximately several hundred hours.

Specifically, in Comparative Example 1, when the peak concentration of Mg was set to 3×10¹⁹ atoms/cm³ or more, a peak with a high Mg concentration appeared in the second region AR2 close to the active layer 19. In such a case, the diffusion of Mg into the active layer and the effect of defects caused by Mg on the active layer become significant, which reduce the element life.

In addition, in Comparative Example 2, when the peak concentration of Mg was set to 3×10¹⁹ atoms/cm³ or less, a position where the peak of the Mg concentration curve appeared became the third region AR3, and the Mg concentration in the second region monotonically decreased toward the active layer. In such a case, the Mg concentration in the second region becomes insufficient, and the carrier injection efficiency decreases due to the decrease in the hole carriers, leading to an increase in the threshold current density. The increase in the threshold current density also reduces the element life.

In contrast, the p-type AlGaN layer in the surface emitting laser of the present invention has the Mg concentration indicated by the Mg concentration curve of less than 1×10¹⁹ atoms/cm³ throughout the entire layer thickness of the p-type AlGaN layer 35, and is the smallest in the first region, and when the region from the peak position at which the concentration is maximum among the peak positions of the Mg concentration in the second region to the peak position at which the concentration is maximum among the peak positions of the Mg concentration in the third region is set as the fourth region, the Mg concentration is equal to or more than 3×10¹⁸atoms/cm³ in the fourth region, and the difference between the maximum value and the minimum value of the Mg concentration in the fourth region is equal to or less than 1.5×10¹⁸ atoms/cm³.

The p-type AlGaN layer in the surface emitting laser of the present invention has the Mg concentration indicated by the Mg concentration curve of less than 1×10¹⁹ atoms/cm³ throughout the entire layer thickness of the p-type AlGaN layer 35, and is the smallest in the first region, and has a region with the Mg concentration of equal to or more than 3×10¹⁸atoms/cm³ and less than 8×10¹⁸ atoms/cm³ from the second region to the third region.

The p-type AlGaN layer 35, which indicates such a Mg profile, can suppress the decrease in the element life caused by the excessive Mg while providing the sufficient hole carrier concentration in the p-type AlGaN layer. The p-type AlGaN layer 35, which indicates such a Mg profile, was achievable by growing it using the method that includes the three steps as illustrated in FIG. 6.

As indicated in Comparative Example 2 described above, conventionally, when the peak concentration of Mg is equal to or less than 3×10¹⁹ atoms/cm³, the Mg concentration in the third region tends to be higher than that in the second region and Mg in the second region tends to be insufficient. If the Mg concentration in the second region is increased, Mg in the third region is further increased to cause a tendency of the excessive Mg concentration in the third region. In this embodiment, the supply amount of the Mg material gas is controlled while taking the memory effect of Mg into account, thereby successfully increasing the Mg concentration in the second region and suppressing the Mg concentration in the third region from becoming excessive.

As the result, a profile close to flat (approximately flat) was obtained from the second region to the third region. It was found that the element life of the surface emitting laser 10 including such a p-type AlGaN layer 35 improved more significantly than the conventional ones. Specifically, as described above, the element life of the conventional surface emitting laser was approximately several hundred hours, whereas, the element life of the surface emitting laser 10 of this embodiment was 5400 hours.

Note that while in the above-described embodiment, the example in which the layer thickness of the p-type AlGaN layer is 10 nm has been described, the layer thickness is not limited thereto. It is preferred that the layer thickness of the p-type AlGaN layer be 7 nm or more and 15 nm or less. If the layer thickness is less than 8 nm, it becomes easier for the overflow of the electron carriers to occur, and the threshold current density is more likely to increase. If the layer thickness exceeds 15 nm, the occurrence of cracks and the increase in the operating voltage may be caused.

In this embodiment, the layer thickness of the first p-type AlGaN layer is preferably 0.4 nm or more and 1 nm or less. If it is less than 0.4 nm, the effects of suppressing the diffusion of Mg into the active layer and the expansion of the defects caused by Mg in the active layer are poor, and if it exceeds 1 nm, the element voltage may increase.

In this embodiment, the design value of the Al composition of the first p-type AlGaN layer is preferably 25% or less. This is because if the Al composition exceeds 25%, the element voltage may increase.

In this embodiment, the design value of the Al composition of the second p-type AlGaN layer is preferably 23% or more and 50% or less. If the Al composition is less than 23%, it becomes easier for the overflow of the electron carriers to occur, and the threshold current density is more likely to increase. If the Al composition exceeds 50%, the effects of the decrease in crystallinity of the p-type AlGaN layer, the occurrence of cracks, the increase in the operating voltage, and the like become more significant.

In this embodiment, the layer thickness of the second p-type AlGaN layer is preferably 3 nm or more and 7 nm or less. If it is less than 3 nm, it is difficult to achieve the Mg concentration of 3×10¹⁸ atoms/cm³ or more in the second region, and if it exceeds 6 nm, the element voltage may increase significantly.

In this embodiment, a design value of an Al composition of the third p-type AlGaN layer is preferably 12% or more and 30% or less. By setting the Al composition of the third p-type AlGaN layer to this range, it is possible to suppress the occurrence of cracks and increase in the operating voltage while also suppressing the overflow of the electron carriers together with the second p-type AlGaN layer.

Note that in the above-described embodiment, a difference between the mean value of the Al compositions in the second region indicated by the Al composition curve and an mean value of the Al compositions in the third region is preferably 3% or more and 18% or less.

If the difference between the mean values of the Al compositions in the second region and the third region becomes 3% or more, the difference between the maximum value and the minimum value of the Mg concentration is more likely to satisfy 1.5× 10¹⁸/cm³ or less in the fourth region between the maximum peak position of the Mg concentration in the second region and the maximum peak position of the Mg concentration in the third region. That is, the Mg concentration is more likely to have an approximately flat shape (approximately the same amount) near the boundary close to the third region and the second region, and the increase in the threshold current density is suppressed, thereby being preferrable. Furthermore, if the difference between the mean values of the Al compositions becomes 8% or more, the Mg concentration is more likely to keep 5×10¹⁸/cm³ or more in the fourth region, thereby being preferrable. On the other hand, if the difference between the mean values of the Al compositions exceeds 18%, degradation in crystallinity starts to occur, thereby being unpreferable.

In the above-described embodiment, a nitride semiconductor multilayer film is used as a lower reflecting mirror. Since the thermal conductivity of the nitride semiconductor multilayer film containing AlInN is low, the resonator length is long. Thus, the threshold current density tends to be particularly high in the surface emitting laser that uses the nitride semiconductor multilayer films as the reflecting mirror, and this in turn tends to cause the carrier overflow. Therefore, it is effective to apply the present invention to the vertical cavity light-emitting element that uses the nitride semiconductor containing AlInN as the reflector.

The configurations in the above-described embodiments and the manufacturing methods are only examples, and can be changed as appropriate according to the application, and the like.

### DESCRIPTION OF REFERENCE SIGNS

- 10: Surface emitting laser
- 11: Substrate
- 15: First multilayer film reflecting mirror
- 17: n-type semiconductor layer
- 19: Active layer
- 21: Intermediate layer
- 23: p-type semiconductor layer
- 25: n-electrode
- 27: Insulating layer
- 29: Translucent electrode
- 31: Second multilayer film reflecting mirror
- 33: p-electrode
- 35: p-type AlGaN layer
- 37: p-type nitride semiconductor layer
- 45: p-type contact layer

## Claims

1. A vertical cavity light-emitting element comprising:
a substrate;
a first multilayer film reflecting mirror as a semiconductor multilayer film in which two semiconductor layers with mutually different refractive indices are stacked alternately a plurality of times on the substrate;
an n-type nitride semiconductor layer formed on the first multilayer film reflecting mirror and made of a nitride semiconductor containing an n-type dopant;
an active layer formed on the n-type nitride semiconductor layer;
a p-type AlGaN layer formed on the active layer and containing Mg as a p-type dopant, the p-type AlGaN layer having a configuration in which three or more AlGaN layers with different Al compositions are stacked;
a p-type nitride semiconductor layer formed on the p-type AlGaN layer, the p-type nitride semiconductor layer being a semiconductor layer made of a nitride semiconductor containing a p-type dopant; and
a second multilayer film reflecting mirror formed on the p-type nitride semiconductor layer and provided in a position opposed to the first multilayer film reflecting mirror, wherein
in an Al composition curve indicating a change in Al composition in a layer thickness direction in the p-type AlGaN layer and a Mg concentration curve indicating a change in Mg concentration in the layer thickness direction in the p-type AlGaN layer analyzed by a secondary ion mass spectrometry (SIMS) of the p-type AlGaN layer,
when a width range at 50% of the peak value of the Al composition curve is defined as the p-type AlGaN layer, and the p-type AlGaN layer is divided into a first region having a layer thickness of 1/10 of the p-type AlGaN layer, a second region having a layer thickness of 2/5 of the p-type AlGaN layer, and a third region having a layer thickness of 1/2 of the p-type AlGaN layer in the layer thickness direction from the active layer side in this order,
a size relationship among the Al compositions indicated by the Al composition curve in the respective regions is the first region < the third region < the second region,
a Mg concentration indicated by the Mg concentration curve is less than 1.2×10¹⁹ atoms/cm³ throughout an entire layer thickness of the p-type AlGaN layer, and the Mg concentration is smallest in the first region among the first region to the third region, and
a region from a peak position at which the concentration is maximum among peak positions of the Mg concentration in the second region to a peak position at which the concentration is maximum among peak positions of the Mg concentration in the third region is set as a fourth region, the Mg concentration is equal to or more than 3×10¹⁸ atoms/cm³ in the fourth region, and a difference between a maximum value and a minimum value of the Mg concentration in the fourth region is equal to or less than 1.5×10¹⁸ atoms/cm³.

2. A vertical cavity light-emitting element comprising:
a substrate;
a first multilayer film reflecting mirror as a semiconductor multilayer film in which two semiconductor layers with mutually different refractive indices are stacked alternately a plurality of times on the substrate;
an n-type nitride semiconductor layer formed on the first multilayer film reflecting mirror and made of a nitride semiconductor containing an n-type dopant;
an active layer formed on the n-type nitride semiconductor layer;
a p-type AlGaN layer formed on the active layer and containing Mg as a p-type dopant, the p-type AlGaN layer having a configuration in which three or more AlGaN layers with different Al compositions are stacked;
a p-type nitride semiconductor layer formed on the p-type AlGaN layer, the p-type nitride semiconductor layer being a semiconductor layer made of a nitride semiconductor containing a p-type dopant; and
a second multilayer film reflecting mirror formed on the p-type nitride semiconductor layer and provided in a position opposed to the first multilayer film reflecting mirror, wherein
in an Al composition curve indicating a change in Al composition in a layer thickness direction in the p-type AlGaN layer and a Mg concentration curve indicating a change in Mg concentration in the layer thickness direction in the p-type AlGaN layer analyzed by a secondary ion mass spectrometry (SIMS) of the p-type AlGaN layer,
when a width range at 50% of the peak value of the Al composition curve is defined as the p-type AlGaN layer, and the p-type AlGaN layer is divided into a first region having a layer thickness of 1/10 of the p-type AlGaN layer, a second region having a layer thickness of 2/5 of the p-type AlGaN layer, and a third region having a layer thickness of 1/2 of the p-type AlGaN layer in the layer thickness direction from the active layer side in this order,
a size relationship among the Al compositions indicated by the Al composition curve in the respective regions is the first region < the third region < the second region,
a Mg concentration indicated by the Mg concentration curve is less than 1.2×10¹⁹ atoms/cm³ throughout an entire layer thickness of the p-type AlGaN layer, and the Mg concentration is smallest in the first region among the first region to the third region, and
the vertical cavity light-emitting element has a region with the Mg concentration of equal to or more than 3×10¹⁸ atoms/cm³ and less than 8×10¹⁸ atoms/cm³ from the second region to the third region.

3. The vertical cavity light-emitting element according to claim 1, wherein
the Mg concentration is less than 8×10¹⁸ atoms/cm³ in the fourth region.

4. The vertical cavity light-emitting element according to claim 2, wherein
a region from a peak position at which the concentration is maximum among peak positions of the Mg concentration in the second region to a peak position at which the concentration is maximum among peak positions of the Mg concentration in the third region is set as a fourth region, and a difference between a maximum value and a minimum value of the Mg concentration in the fourth region is equal to or less than 1.5×10¹⁸ atoms/cm³.

5. The vertical cavity light-emitting element according to claim 1 or 2, wherein
the Mg concentration in the p-type AlGaN layer indicated by the Mg concentration curve is less than 1×10¹⁹ atoms/cm³ throughout the entire layer thickness.

6. The vertical cavity light-emitting element according to claim 1 or 2, wherein
the Mg concentration in the first region indicated by the Mg concentration curve is less than 2×10¹⁸ atoms/cm³.

7. The vertical cavity light-emitting element according to claim 1 or 2, wherein
a difference between the Al composition in the second region and the Al composition in the third region indicated by the Al composition curve is 3% or more and 18% or less.

8. A manufacturing method of a vertical cavity light-emitting element by a metal-organic chemical vapor deposition (MOCVD), comprising:
a step of forming a first multilayer film reflecting mirror by alternately growing two semiconductor layers with mutually different refractive indices on a substrate;
an n-type nitride semiconductor layer growth step of growing an n-type nitride semiconductor layer on the first multilayer film reflecting mirror while supplying a material gas of n-type dopant;
a step of forming an active layer on the n-type nitride semiconductor layer;
a p-type AlGaN layer growth step of growing a p-type AlGaN layer as an AlGaN layer having a p-type conductivity type on the active layer while supplying a Mg material gas as a p-type dopant;
a p-type nitride semiconductor layer growth step of growing a p-type nitride semiconductor layer on the p-type AlGaN layer; and
a step of forming a second multilayer film reflecting mirror opposed to the first multilayer film reflecting mirror on the p-type nitride semiconductor layer, wherein
the p-type AlGaN layer growth step includes:
a first growth step of growing a first p-type AlGaN layer by supplying a nitrogen source gas and a Ga material gas at a predetermined supply amount, supplying an Al material gas at a first supply amount, and supplying the Mg material gas at a second supply amount while increasing a growth temperature from a first temperature to a second temperature;
a second growth step of growing a second p-type AlGaN layer by a maintaining step of maintaining the supply amount of the Mg material gas at the second supply amount for a first growth time while maintaining the supply amounts of the nitrogen source gas, the Ga material gas, and the Al material gas used in the first growth step after the first growth step, and thereafter, by a low Mg supply step of maintaining the supply amount of the Mg material gas for a second growth time after changing the supply amount to a third supply amount, the third supply amount being lower than the second supply amount; and
a third growth step of growing a third p-type AlGaN layer while supplying the Al material gas at a fourth supply amount lower than the first supply amount and supplying the Mg material gas at a fifth supply amount lower than the second supply amount, after the second growth step.

9. The manufacturing method according to claim 8, wherein
the third supply amount is equal to or less than one-tenth of the second supply amount.

10. The manufacturing method according to claim 8, wherein
the first growth time is equal to or less than the second growth time.

11. The manufacturing method according to claim 8, wherein
the fifth supply amount is equal to or less than one-tenth of the second supply amount.

12. The manufacturing method according to claim 8, wherein
in the p-type AlGaN layer growth step, the atmosphere gas is nitrogen gas.

13. A vertical cavity light-emitting element manufactured by the manufacturing method according to claim 9.
